# EUROPÄISCHE PATENTSCHRIFT

(11) **EP 3 232 282 B1**
(45) Veröffentlichungstag und Bekanntmachung des Hinweises auf die Patenterteilung: **12.09.2018**
(21) Anmeldenummer: 16164829.0
(22) Anmeldetag: 12.04.2016
(51) Int. Cl.: G05B 23/02, G05B 19/425, G05B 19/4063, G05B 19/418, G06F 17/50

(54) **DIAGNOSEEINRICHTUNG UND VERFAHREN ZUR ÜBERWACHUNG DES BE-TRIEBS EINER TECHNISCHEN ANLAGE**
DIAGNOSTIC DEVICE AND METHOD FOR MONITORING THE OPERATION OF A TECHNICAL PLANT
DISPOSITIF DE DIAGNOSTIC ET PROCEDE DE SURVEILLANCE DU FONCTIONNEMENT D'UNE INSTALLATION TECHNIQUE

(43) Veröffentlichungstag der Anmeldung: 18.10.2017
(73) Patentinhaber: Siemens Aktiengesellschaft, 80333 München (DE)
(72) Erfinder: Bierweiler, Thomas, 76131 Karlsruhe (DE); Labisch, Daniel, 76149 Karlsruhe (DE)

(56) Entgegenhaltungen:
- EP-A2- 0 446 036
- US-A1- 2007 244 841

## Beschreibung

Die Erfindung betrifft eine Diagnoseeinrichtung zur Überwachung des Betriebs einer technischen Anlage mit einem Automatisierungssystem nach dem Oberbegriff des Anspruchs 1 sowie ein entsprechendes Diagnoseverfahren nach dem Oberbegriff des Anspruchs 9.

Wartung und Instandhaltung von automatisierungstechnischen Anlagen können verbessert werden, wenn die korrekte Funktion von Teilanlagen oder Komponenten überwacht wird. Bei nachlassender Funktionsfähigkeit kann gezielt an der richtigen Stelle der Anlage mit Maßnahmen zur Wartung, Instandhaltung oder Fehlerbeseitigung eingegriffen werden.

So ist aus der europäischen Patentanmeldung EP 0 446 036 A2 eine Steuervorrichtung bekannt, welche eine Anlage - wie etwa ein Walzwerk oder eine Kläranlage - automatisch, auf der Grundlage der von dieser Anlage empfangenen Daten steuert. Zuerst werden die Daten analysiert, um eine Eigenschaft der Daten abzuleiten (engl. feature extraction), und dann wird diese Eigenschaft untersucht, um ein Problem beim Betrieb der Anlage zu bestimmen (engl. problem recognition). Anschließend wird dieses Problem automatisch analysiert (engl. cause identification and knowledge management), um eine oder mehrere Strategien zur Lösung abzuleiten (engl. strategy determination); dann kann die Anlage auf der Grundlage dieser Strategie gesteuert werden. Die Analyse kann somit automatisch im Rahmen eines sich selbstorganisierenden Mechanismus, betrieben werden, was ein höheres Maß an Flexibilität und Reaktionsfähigkeit der automatischen Steuerung ermöglicht.

Aus dem Aufsatz "Monitoring of Complex Industrial Processes based on Self-Organising Maps and Watershed Transformations" von Christian W. Frey, Fraunhofer Institute IOSB, gefunden im Internet am 11.03.2016 unter der Adresse www.iosb.fraunhofer.de/servlet/is/22544/Paper_ICIT2012_Frey.p df?command=downloadContent&filename=Paper_ICIT2012_Frey.pdf, ist ein Diagnoseverfahren zur Überwachung komplexer industrieller Prozesse bekannt, in welchem eine selbstorganisierende Karte anhand von Prozessvariablen, das heißt anhand der erfassten Werte von Messgrößen und der an den Prozess ausgegebenen Werte der Stellgrößen, für ein fehlerfreies Verhalten des Prozesses trainiert wird. Als "selbstorganisierende Karten", Kohonenkarten oder Kohonennetze (nach Teuvo Kohonen; englisch self-organizing map, SOM bzw. self-organizing feature map, SOFM) bezeichnet man laut Wikipedia vom 04.03.2016 eine Art von künstlichen neuronalen Netzen. Sie sind als unüberwachtes Lernverfahren ein leistungsfähiges Werkzeug des Data-Mining. Ihr Funktionsprinzip beruht auf der biologischen Erkenntnis, dass viele Strukturen im Gehirn eine lineare oder planare Topologie aufweisen. Anhand der gemäß obigem Aufsatz vorbestimmten selbstorganisierenden Karte wird das spätere Betriebsverhalten mit dem erlernten fehlerfreien Verhalten verglichen. Auf diese Weise wird ein abweichendes Verhalten erkannt, das anschließend auf Ursachen und mögliche Fehler beim Betrieb des Prozesses analysiert werden kann.

Auch aus der US-Patentanmeldung US 2007/0244841 A1 ist eine Diagnosevorrichtung und ein entsprechendes Verfahren zur Datenverarbeitung bekannt, bei dem jeder Parameter eines Objekts, wie beispielsweise einer Maschine, die in mehreren Betriebsmodi arbeiten kann, präzise diagnostiziert werden kann. Dabei werden für jeden der Betriebsmodi eine Vielzahl von normalen Datensätzen detektiert, von denen jeder Datensatz Werte von n Parametern enthält. Anschließend werden für jeden Betriebsmodus unter Verwendung normaler Datensätze selbstorganisierendes Karten erstellt. Danach werden aus den normalen Datensätzen abnormale Datensätze erstellt und die selbstorganisierenden Karten der Datensätze mit dem höchsten Ähnlichkeitsgrad bestimmt.

Nachteilig bei den bekannten Diagnoseverfahren ist jedoch, dass das Zeitverhalten eines auf einer technischen Anlage ablaufenden Prozesses, welches möglicherweise ebenfalls für eine Diagnose hilfreiche Informationen liefern könnte, nicht betrachtet wird.

Der Erfindung liegt daher die Aufgabe zugrunde, eine Diagnoseeinrichtung und ein Diagnoseverfahren zur Überwachung des Betriebs einer technischen Anlage zu schaffen, bei welchen Informationen über das Zeitverhalten in die Überwachung einbezogen werden.

Zur Lösung dieser Aufgabe weist die erfindungsgemäße Diagnoseeinrichtung die im kennzeichnenden Teil des Anspruchs 1 angegebenen Merkmale auf. In den abhängigen Ansprüchen sind Weiterbildungen der Erfindung, in Anspruch 9 ein Diagnoseverfahren, in Anspruch 10 ein Computerprogramm zur Durchführung des Diagnoseverfahrens und in Anspruch 11 ein entsprechendes Computerprogrammprodukt beschrieben.

Die Erfindung hat den Vorteil, dass sich die neuartige Diagnose durch große Flexibilität und besondere Einfachheit auszeichnet. Aus zuvor fehlerfrei durchlaufenen Schrittketten wird die selbstorganisierende Karte eingelernt und parametriert. Dabei werden zeitliche Schwankungen in der Karte abgebildet. Sowohl zeitliche Unter- als auch Überschreitungen werden automatisch berücksichtigt. Auch der Fall, dass unterschiedlich lange Ausführungszeiten einzelner Schritte auftreten, also sowohl lange als auch kurze Ausführungszeiten, nicht jedoch Ausführungszeiten, deren Dauer zwischen diesen Extremen liegt und trotzdem fehlerfreie Durchläufe kennzeichnen, wird durch die selbstorganisierende Karte abgebildet. Auf diese Weise können die Diagnosemöglichkeiten somit weiter verbessert werden.

Vorteilhaft ist das neue Diagnoseverfahren beinahe an allen verfahrens-, fertigungs- und prozesstechnischen Anlagen anwendbar, da technische Abläufe üblicherweise durch Schrittketten, die auch als Ablaufketten oder Ablaufsteuerungen bezeichnet werden, gesteuert werden. Die Dauer der einzelnen Schritte kann sowohl produktionsbedingten als auch durch Fehler bedingten Schwankungen unterliegen. Die Zeitüberwachung der Schritte ist hilfreich zur Erkennung von Abweichungen, da diese bereits als Indizien für Fehlerfälle angesehen werden können.

Prinzipiell könnte die Zeitdauer eines einzelnen Schrittes einer Schrittkette durch den Vergleich mit einer maximal zulässigen Zeitdauer überwacht werden. Ebenfalls könnte eine Lösung darin gesehen werden, die Überwachung einer minimalen Zeitdauer durchzuführen. Diese Vorgehensweisen wären jedoch sehr unflexibel, da zum Beispiel Produktionsschwankungen, die mehrere Schritte einer Schrittkette betreffen, in nachteiliger Weise nur schwer berücksichtigt und kaum erkannt werden können. Demgegenüber ist die Flexibilität und Zuverlässigkeit der Diagnoseaussage bei der erfindungsgemäßen Diagnose erheblich besser.

Die hohe Flexibilität der Diagnose und die leichte Anwendbarkeit werden insbesondere dadurch erreicht, dass in einem automatischen Lernvorgang für jeden Knoten der selbstorganisierenden Karte, der einen fehlerfreien Durchlauf der Schrittkette repräsentiert, automatisch ein n-Tupel mit n-Koordinaten bestimmt wird, wobei jede Koordinate für die Zeitdauer der Ausführung eines beim Einlernvorgang durchlaufenden Schrittes steht. Als Eingangsgrößen werden also beim Einlernen der selbstorganisierenden Karte die Zeitdauern der einzelnen Schritte einer Schrittkette verwendet. Da die Durchlaufzeiten bei verschiedenen Durchläufen variieren können, selbst wenn kein Fehler auftritt, werden zum Einlernen der selbstorganisierenden Karte die Zeiten mehrerer gut verlaufener Durchläufe der Schrittketten als Trainingsdaten genutzt. Die selbstorganisierende Karte speichert beim Einlernen an jedem Knoten typische Ablaufzeiten für die einzelnen Schritte ab. Zu Beginn des Einlernverfahrens kann beispielsweise eine Karte der Größe 8x12 Knoten verwendet werden. Selbstverständlich sind auch davon abweichende Größen verwendbar. Nach dem Einlernen können die Trainingsdaten zur Überprüfung der Kartengröße genutzt werden. Ist die Karte zu groß, so werden die einzelnen Knoten der Karte nicht oder nur einmal von den Trainingsdaten getroffen. Wenn sich eine Karte als zu groß erwiesen hatte, kann in einem nächsten Einlernvorgang eine etwas kleinere Kartengröße gewählt werden und der Einlernvorgang erneut gestartet werden. Die neue Art der Diagnose erfordert somit in vorteilhafter Weise kaum Kenntnisse des Bedieners über die zu überwachende Anlage und ist praktisch universell anwendbar. Weichen im Diagnosebetrieb Ausführungszeiten einzelner Schritte eines zu prüfenden Durchlaufs von den an den Knoten der zuvor eingelernten selbstorganisierenden Karte zu sehr ab, so stellt dies ein Indiz für einen Fehler in der überwachten Anlage dar. Erst für die sich anschließende Analyse der Fehlerursache werden eventuell genauere Kenntnisse über den jeweils auf der überwachten Anlage ablaufenden Prozess benötigt.

Durch Auswertung eines Datensatzes mit den Ausführungszeiten jedes Schrittes für einen zu prüfenden Durchlauf anhand der selbstorganisierenden Karte werden Abweichungen des Zeitverhaltens beim zu prüfenden Durchlauf von zuvor erlernten und in der vorbestimmten selbstorganisierenden Karte abgelegten Ausführungszeiten fehlerfreier Durchläufe detektiert und angezeigt. Vorzugsweise wird zur Detektion einer Abweichung des Zeitverhaltens der geringste kartesische Abstand zwischen dem Datensatz des zu prüfenden Durchlaufs und den Knoten der selbstorganisierenden Karte bestimmt. Derjenige Knoten der Karte, welcher den geringsten kartesischen Abstand zum Datensatz des zu prüfenden Durchlaufs aufweist, wird als Gewinnerknoten ermittelt.

Gemäß einer besonders vorteilhaften Ausführungsform der Erfindung wird als Diagnoseaussage eine Abweichung vom Normalverhalten bei dem zu prüfenden Durchlauf der Schrittkette dann angezeigt, wenn der Abstand zum Gewinnerknoten einen vorbestimmten Schwellwert übersteigt. Ebenso wie das Erlernen der Knoten der selbstorganisierenden Karte können die Schwellwerte anhand der Datensätze fehlerfreier Durchläufe automatisch ermittelt werden. Dazu können mit den Datensätzen die jeweiligen Gewinnerknoten ermittelt und die jeweiligen kartesischen Abstände zwischen den Datensätzen und den zugehörigen Gewinnerknoten bestimmt werden. Als Schwellwert kann dann der sich jeweils zu einem Datensatz ergebende Abstand zu seinen Gewinnerknoten, zur Vermeidung von Fehldiagnosen jeweils erhöht um einen Sicherheitsaufschlag von beispielsweise 5 bis 50%, vorzugsweise 15%, berechnet und auf diese Weise vorbestimmt werden.

Prinzipiell könnte die Vorbestimmung der Knoten der selbstorganisierenden Karte auf beliebige Weise, beispielsweise durch manuelle Eingabe der Ausführungszeiten durch einen Bediener, erfolgen. Mit Vorteil kann jedoch zur Vorbestimmung der selbstorganisierenden Karte ein einfach durchzuführendes Lernverfahren angewendet werden, welches keine komplizierten Eingaben eines Bedieners und kaum Kenntnisse über den Betrieb der Anlage erfordert. Dazu werden vor einem zu prüfenden Durchlauf im Datenspeicher mehrere, einen fehlerfreien Betrieb der Anlage kennzeichnende Datensätze abgespeichert und anhand dieser Datensätze durch das Lernverfahren die n-Tupel mit den Zeitdauern für fehlerfreie Durchläufe für die Knoten der Karte berechnet und an diesen abgelegt, d. h. den Knoten zugeordnet abgespeichert. Die auf diese Weise vorbestimmte Karte kann unmittelbar zur Auswertung eines zu prüfenden Durchlaufs verwendet werden. Selbstverständlich können durch einen Bediener aber auch nachträglich noch Korrekturen an den einzelnen Daten der Karte vorgenommen werden.

Die neuartige Diagnose ist selbst dann anwendbar, wenn in einer Schrittkette Verzweigungen auftreten, aufgrund welcher alternative Schritte der Schrittkette bei verschiedenen Durchläufen ausgeführt werden. Prinzipiell wäre es möglich, für jeden der alternativen Pfade, die bei Durchläufen gegangen werden, eine selbstorganisierende Karte zu bestimmen und zur anschließenden Auswertung bei der Diagnose zu verwenden.

Dieser zusätzliche Aufwand kann vorteilhaft umgangen werden, indem für alle eventuell ausführbaren Schritte, auch für diejenigen, die in nicht allen Durchläufen vorkommen, Koordinaten der n-Tupel angelegt werden. In einem zu prüfenden Durchlauf wird dann für nicht ausgeführte Schritte der Wert "Null" als Zeitdauer ermittelt und für die Koordinate des Datensatzes abgespeichert, die für den nicht ausgeführten Schritt vorgesehen ist.

Selbst Schrittketten mit Schleifen, aufgrund welcher Schritte der Schrittketten bei einem Durchlauf mehrfach ausführbar sind, können überwacht werden. Beim Erstellen und Einlernen der selbstorganisierenden Karte anhand fehlerfreier Durchläufe wird für jede Ausführung eines Schritts der Schrittkette in einem Durchlauf eine Koordinate des n-Tupels eingerichtet, und zwar bei Schritten, die sich in einer Schleife befinden, für jeden neuen Schleifendurchlauf. Wird in einem zu prüfenden Durchlauf eine Schleife seltener durchlaufen, so wird an den Koordinaten der nicht mehr durchlaufenen Schleifenschritte jeweils der Wert "Null" abgespeichert. In vorteilhafter Weise kann diese Art der Überwachung auch in Situationen sinnvoll angewendet werden, in welchen die Zeitdauer der Ausführung eines Schritts von der Anzahl der zuvor erfolgten Schleifendurchläufe abhängt. In praktischen Fällen können nämlich auch die nachfolgenden Schritte von der Anzahl der Schleifendurchläufe beeinflusst werden. Dieses Verhalten wird somit ebenfalls mittels selbstorganisierender Karten überwachbar. Aus den Trainingsdaten, das heißt der Datensätze fehlerfreier Durchläufe, die beim Einlernen der selbstorganisierenden Karte angewendet werden, kann zudem die in fehlerfreien Durchläufen vorkommende maximale Anzahl der Schleifendurchläufe bestimmt werden. Wird diese maximale Anzahl bei der späteren Überwachung der Anlage überschritten, deutet dies ebenfalls auf einen möglicherweise vorliegenden Fehler in der Anlage hin. Wird die maximale Anzahl der Durchläufe bei der Überwachung dagegen nicht erreicht, so wird an den Koordinaten, die den nicht durchlaufenen Schritten zugeordnet sind, jeweils der Wert "Null" für die Zeitdauer der Ausführung des jeweiligen Schritts gesetzt.

Die Diagnoseeinrichtung kann in einer Automatisierungsumgebung vorteilhaft als Software-Funktionsbaustein ausgebildet werden, der in einer grafischen Bedienoberfläche eines Engineering-Systems mit Funktionsbausteinen von Automatisierungsprogrammen verschaltbar und zum Betrieb der Diagnoseeinrichtung beispielsweise in ein Automatisierungsgerät ladbar ist. Auf einem so genannten Faceplate zur Realisierung einer Mensch-Maschine-Schnittstelle auf einem Bedien- und Beobachtungsgerät der automatisierungstechnischen Anlage werden dann erkannte Abweichungen von Ausführungszeiten einzelner Schritte, die auf einen Fehler in der Anlage hindeuten, zur Anzeige gebracht. Auf diesem Bedien- und Beobachtungssystem können durch einen Bediener, falls gewünscht, Änderungen an der selbstorganisierenden Karte oder an den Schwellwerten, die den einzelnen Knoten quasi als Abweichungssensitivität zugeordnet sind, vorgenommen werden.

In besonders vorteilhafter Weise kann die neue Diagnoseeinrichtung zur Überwachung des Betriebs einer technischen Anlage, insbesondere der Datenspeicher und die Auswerteeinrichtung, in einer Software-Umgebung zur Cloud-basierten Anlagenüberwachung implementiert werden. Eine derartige Software-Umgebung stellt beispielsweise der datenbasierte Remote-Service "Control Performance Analytics" der Siemens AG dar. Daten aus Kundenanlagen werden mit Hilfe von Software-Agenten gesammelt, aggregiert, und an ein Siemens-Service-Operation-Center geschickt, in welchem sie auf einem Remote-Service-Rechner abgespeichert werden. Dort werden sie mit Hilfe von verschiedenen "Data Analytics"-Software-Applikationen halbautomatisch ausgewertet. Bei Bedarf können für den Remote-Service besonders geschulte Experten auf dieser Datenbasis hocheffizient arbeiten. Die Ergebnisse der Datenanalyse können auf einem Monitor des Remote-Service-Rechners angezeigt und/oder auf einem Sharepoint bereitgestellt werden, so dass sie vom Endkunden, das heißt dem Bediener der technischen Anlage, zum Beispiel in einem Browser betrachtet werden können.

Das Diagnoseverfahren wird somit bevorzugt in Software oder in einer Kombination Soft-/Hardware implementiert, so dass die Erfindung auch ein Computerprogramm mit durch einen Computer ausführbaren Programmcodeanweisungen zur Implementierung des Diagnoseverfahrens betrifft. In diesem Zusammenhang betrifft die Erfindung auch ein Computerprogrammprodukt, insbesondere einen Datenträger oder ein Speichermedium, mit einem durch einen Computer ausführbaren derartigen Computerprogramm. Ein solches Computerprogramm kann, wie oben beschrieben, in einem Speicher eines Automatisierungsgeräts vorgehalten oder in diesen geladen werden, so dass beim Betrieb des Automatisierungsgeräts die Überwachung des Betriebs der technischen Anlage automatisch durchgeführt wird, oder das Computerprogramm kann bei einer Cloud-basierten Überwachung einer technischen Anlage in einem Speicher eines Remote-Service-Rechners vorgehalten oder in diesen ladbar sein.

Anhand der Zeichnungen, in denen ein Ausführungsbeispiel der Erfindung dargestellt ist, werden im Folgenden die Erfindung sowie Ausgestaltungen und Vorteile näher erläutert.

Es zeigen
- Figur 1: ein Beispiel für eine technische Anlage,
- Figur 2: ein Beispiel einer Schrittkette, und
- Figur 3: ein Ergebnisdiagram der Auswertung verschiedener geprüfter Durchläufe.

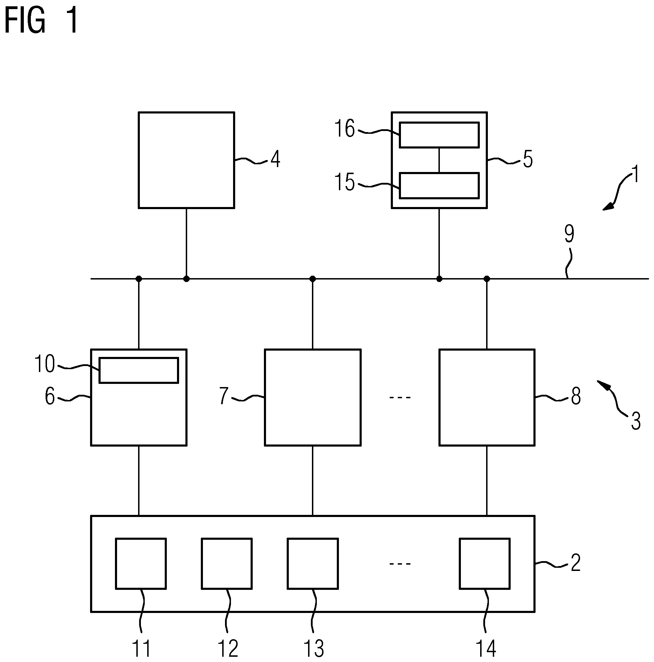

Figur 1 zeigt in vereinfachter schematischer Darstellung als Beispiel eine prozesstechnische Anlage 1, in der ein Prozess 2 mittels eines Automatisierungssystems 3 gesteuert wird. Das Automatisierungssystem 3 enthält ein Planungs- und Engineering-Werkzeug 4, ein Bedien- und Beobachtungsgerät 5 und eine Vielzahl von Automatisierungsgeräten 6, 7, 8, die über ein Bussystem 9 zur Datenkommunikation miteinander verbunden sind. Die Automatisierungsgeräte 6, 7, 8 steuern den technischen Prozess 2 nach Maßgabe von Automatisierungsprogrammen, von welchen beispielhaft in Figur 1 ein Automatisierungsprogramm 10 eingezeichnet ist. Das Automatisierungsprogramm 10 beispielsweise besteht meist aus mehreren Funktionsbausteinen, welche mit weiteren, im Automatisierungssystem 3 verteilten Funktionsbausteinen in Wechselwirkung stehen können. Zur Steuerung des Prozesses 2 werden vielfältige Feldgeräte 11, 12, 13, 14 zur Prozessinstrumentierung eingesetzt. Messumformer dienen zur Erfassung von Prozessvariablen, wie beispielsweise Temperatur, Druck, Durchflussmenge, Füllstand, Dichte oder Gaskonzentration eines Mediums. Durch Stellglieder kann der Prozessablauf in Abhängigkeit von erfassten Prozessvariablen beispielsweise den Vorgaben des Automatisierungsprogramms 10 entsprechend beeinflusst werden. Als Beispiele für Stellglieder seien ein Regelventil, eine Heizung oder eine Pumpe genannt. Zur Überwachung des Betriebs der Anlage 1 wird eine Vielzahl von Datensätzen, die für den Betrieb der Anlage kennzeichnend sind, erfasst und in einem Datenspeicher 15 abgespeichert. Mittels einer Auswerteeinrichtung 16 werden die Datensätze, die Ausführungszeiten einzelner Schritte von Schrittketten enthalten, ausgewertet, um eine Diagnoseaussage zu bestimmen und einem Bediener anzuzeigen, damit eventuell geeignete Maßnahmen zur Fehlerbehandlung getroffen werden können.

In der technischen Anlage 1 werden technische Abläufe durch Schrittketten, die auch als Ablaufketten bezeichnet werden können, gesteuert. Eine Schrittkette stellt eine Ablauffolge von Verarbeitungs- oder Produktionsschritten dar, die beispielsweise in einem Automatisierungsprogramm hinterlegt ist. Die Dauer der einzelnen Schritte kann sowohl produktionsbedingten als auch durch Fehler bedingten Schwankungen unterliegen. Die Zeitüberwachung der Schritte ist hilfreich zur Erkennung von Abweichungen und Fehlerfällen.

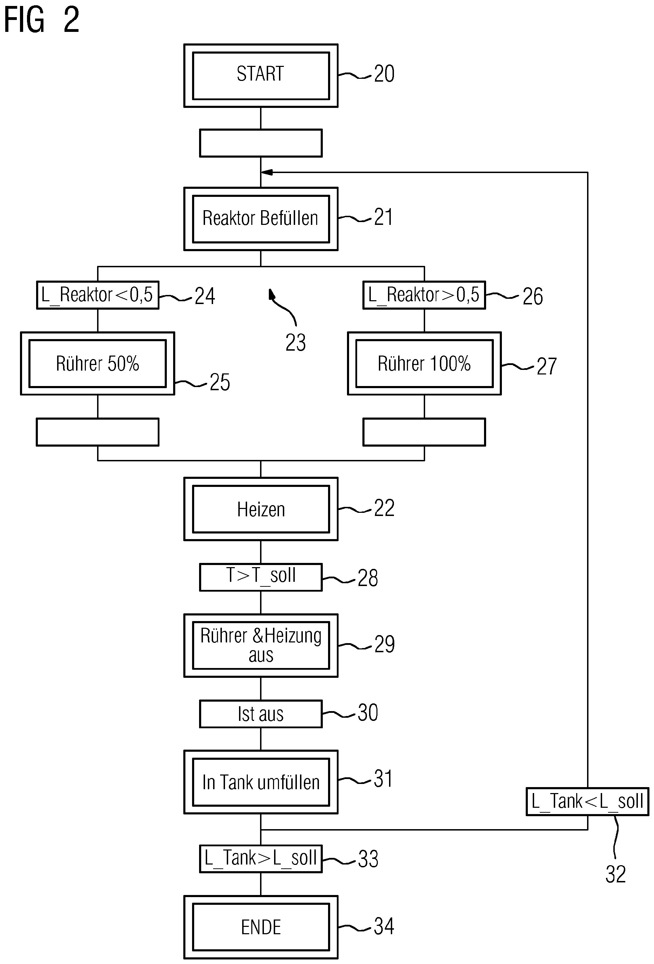

Eine als Beispiel im Folgenden beschriebene Schrittkette beginnt gemäß Figur 2 mit einem Schritt 20, der mit dem Wort "START" beschriftet ist. Schritte, welche für das Verständnis der vorliegenden Erfindung keinerlei Bedeutung haben, wurden in Figur 2 nicht mit einer Beschriftung versehen. In einem Schritt 21, der die Beschriftung "Reaktor Befüllen" trägt, wird ein Reaktor befüllt, dessen Inhalt anschließend mittels eines Rührers durchmischt wird. Gleichzeitig wird der Reaktor entsprechend einem Schritt 22 beheizt, der mit der Beschriftung "Heizen" versehen ist. Da unterschiedliche Füllmengen im Reaktor auftreten können, wird die Rührerleistung je nach Füllstand unterschiedlich gewählt. Die Schrittkette weist daher eine Verzweigung 23 auf zwei alternative Pfade auf. Ist der Füllstand weniger als die Hälfte, so ist eine Bedingung 24 mit der Beschriftung "L_Reaktor<0,5" erfüllt, und der Rührer wird mit 50% seiner Leistung in einem Schritt 25 mit der Beschriftung "Rührer 50%" betrieben. Bei einem Füllstand über diesem Wert ist dagegen eine Bedingung 26 mit der Beschriftung "L_Reaktor>0,5" erfüllt, und die Betriebsleistung des Rührers beträgt 100% entsprechend einem Schritt 27 mit der Beschriftung "Rührer 100%". Beide alternative Pfade münden in den bereits erwähnten Schritt 22 mit der Beschriftung "Heizen". Ist die Solltemperatur erreicht, so ist das Produkt fertig und kann in einen nachgelagerten Tank umgefüllt werden. Es wird also eine Bedingung 28 mit der Beschriftung "T>T_soll" geprüft und erst bei deren Erfüllung zu dem sich anschließenden Schritt 29 mit der Beschriftung "Rührer & Heizung aus" übergegangen. In einer Abfrage 30 wird das Abschalten der genannten Komponenten überprüft. Die Abfrage 30 trägt folglich die Beschriftung "ist aus". Ein Schritt 31 mit der Beschriftung "In Tank umfüllen" schließt sich an, in welchem das Produkt in den nachgelagerten Tank umgefüllt wird. Die Schritte 21 bis 31 werden solange wiederholt, bis im Tank die gewünschte Menge des Produkts ist. Ist also gemäß einer Bedingung 32 mit der Beschriftung "L_Tank<L_soll" der Füllstand des Tanks kleiner als der Sollfüllstand, so wird die Schleife erneut durchlaufen. Übersteigt dagegen der Füllstand des Tanks gemäß einer Bedingung 33 mit der Beschriftung "L_Tank>L_soll" diesen Grenzwert, so endet die Schleife, und es wird zu einem letzten Schritt 34 mit der Beschriftung "ENDE" übergegangen und die Schrittkette beendet.

Ein im realen Betrieb auftretendes Problem stellt beispielsweise das Fouling, d. h. Ablagerungen an Innenwänden, eines zum Aufheizen verwendeten Wärmetauschers dar. Ein stärkeres Fouling äußert sich in einem schlechteren Wärmeübergang und damit einer Verlängerung der Zeitdauer der Ausführung des Schritts 22, welcher den Aufheizvorgang repräsentiert. Da sich zudem jedoch der Reaktorfüllstand in den verschiedenen Durchläufen der oben beschriebenen Schleife unterscheiden kann, variiert die Dauer der Aufheizphase zwischen den einzelnen Schleifendurchläufen ohnehin stark. Eine reine Überwachung der Zeitdauer der Ausführung des Schritts 22 und Vergleich mit einem festen Grenzwert wäre daher wenig geeignet und könnte nur zu einer Diagnoseaussage von geringer Aussagekraft führen. Gemäß dem neuen Diagnoseverfahren werden dagegen vorteilhaft für jeden Schleifendurchlauf automatisch verschiedene Schwellwerte berechnet, durch deren Auswertung eine erheblich zuverlässigere Diagnoseaussage erhalten werden kann.

Die Überwachung der Zeitdauern, die zur Ausführung einzelner Schritte beispielsweise der in Figur 2 gezeigten Schrittkette benötigt werden, wird nun anhand einer selbstorganisierenden Karte generisch gelöst. Als Datensätze, die den Betrieb der Anlage kennzeichnen, werden somit die Zeitdauern der einzelnen Schritte für Durchläufe einer Schrittkette verwendet. Zum Einlernen der selbstorganisierenden Karte werden die Zeiten mehrerer gut verlaufener Durchgänge der Schrittketten als Trainingsdaten benutzt. Nach dem Einlernen wird eine selbstorganisierende Karte erhalten, die an jedem Knoten Datensätze in Form von n-Tupeln aufweist, wobei jede Koordinate des n-Tupels für die Ausführungszeit eines Schritts bei fehlerfreiem Durchlauf steht. Für den Start des Einlernverfahrens kann beispielsweise eine Karte der Größe 8x12 Knoten verwendet werden. Nach dem Einlernen können die Trainingsdaten zur Überprüfung der Kartengröße genutzt werden. Ist die Karte zu groß, so werden manche Knoten der Karte nicht oder nur einmal von den Trainingsdaten getroffen. Wenn die Karte zu groß ist, wird für das weitere Lernverfahren eine etwas kleinere Kartengröße gewählt und diese Karte erneut anhand der Trainingsdaten eingelernt.

In einem weiteren Schritt werden Schwellwerte, die zur Detektion einer Abweichung vom Normalverhalten bei einem zu prüfenden Durchlauf der Schrittkette genutzt werden, automatisch anhand einer Auswertung von Datensätzen für fehlerfreie Durchläufe abgeleitet. Dazu werden mit den Datensätzen die jeweiligen Gewinnerknoten ermittelt und die maximalen kartesischen Abstände zu diesen bestimmt. Als Schwellwert wird dann der maximale Abstand um einen Sicherheitsaufschlag erhöht, der beispielsweise zwischen 5 und 50%, vorzugsweise 15%, betragen kann. Bei Überschreiten eines derartigen Schwellwerts im späteren Betrieb der Anlage wird die Diagnoseaussage erhalten, dass eine Abweichung des Datensatzes für einen zu prüfenden Durchlauf von der erlernten selbstorganisierenden Karte vorliegt, welche möglicherweise auf einen Fehler in der Anlage deutet.

Liegen Verzweigungen, wie beispielsweise die in Figur 2 dargestellte Verzweigung 23, in Schrittketten vor, so werden die aufgrund der Verzweigung nicht ausgeführten Schritte im Datensatz eines zu prüfenden Durchlaufs ebenfalls berücksichtigt, und zwar indem den nicht ausgeführten Schritten einfach der Wert "Null" für die Zeitdauer ihrer Ausführung zugeordnet wird. Das hat den Vorteil, dass bei einer Überwachung einer Anlage anhand einer selbstorganisierenden Karte nun auch Anwendungsfälle sinnvoll überwacht werden können, bei welchen die Zeitdauern einzelner Schritte, die sich in Schleifen befinden, von der Anzahl der bereits erfolgten Schleifendurchläufe abhängen. Weiterhin kann durch diese Vorgehensweise der Fall behandelt werden, in welchem die Zeitdauern der Ausführung von Schritten, welche der Schleife nachgeordnet sind, von der Anzahl der zuvor erfolgten Schleifendurchläufe beeinflusst werden. Selbst ein derartiges Verhalten kann nun durch die Anwendung einer selbstorganisierenden Karte berücksichtigt werden. Aus den Trainingsdaten, das heißt den Datensätzen zuvor erfasster und abgespeicherter fehlerfreier Durchläufe, die zum Erlernen der selbstorganisierenden Karte genutzt werden, wird die maximale Anzahl der Durchläufe einer Schleife bestimmt. Wird ein Schritt aufgrund einer Schleife mehrfach durchlaufen, so werden die Zeitdauern der Ausführung des Schritts für jeden Durchlauf eingelernt. Die Zeitdauern für nicht durchlaufene Schritte des n-Tupels der selbstorganisierenden Karte bis zur erlernten maximalen Anzahl werden analog zur Vorgehensweise bei Verzweigungen auf den Wert "Null" gesetzt.

Prinzipiell könnten anstelle des Werts "Null" auch andere Werte für nicht durchlaufene Schritte gesetzt werden. Der Wert "Null" zeichnet sich jedoch durch besonders hohe Plausibilität für den Anwender der Diagnose aus.

Während des Betriebs der Anlage werden zu seiner Überwachung zu prüfende Durchläufe von Schrittketten anhand der zuvor eingelernten selbstorganisierenden Karte ausgewertet. Für jeden zu prüfenden Durchlauf werden die Zeitdauern der Ausführung der einzelnen Schritte erfasst, in einem Datenspeicher hinterlegt und mittels einer Auswerteeinrichtung ausgewertet. Bei der Auswertung wird derjenige Knoten der selbstorganisierenden Karte bestimmt, welcher den kleinsten kartesischen Abstand zum Datensatz des jeweils zu prüfenden Durchlaufs aufweist. Der Abstand wird mit einem vorbestimmten Schwellwert verglichen, welcher dem jeweiligen Knoten zugeordnet ist. Wird der Schwellwert überschritten, so liegt eine Abweichung vom Normalverhalten des Anlagenbetriebs vor, deren Ursache ein Anlagenfehler sein kann. Beispielsweise auf einem Bedien- und Beobachtungsgerät (5 in Figur 1) wird dies als Diagnoseaussage angezeigt, so dass ein Bediener eine weitere Diagnose veranlassen oder geeignete Wartungsmaßnahmen ergreifen kann.

Durch Vergleich der Ausführungszeiten jedes Schrittes eines zu prüfenden Durchlaufs mit den als Koordinaten des n-Tupels an den Knoten der selbstorganisierenden Karte hinterlegten Ausführungszeiten fehlerfreier Durchläufe kann ermittelt werden, welche Einzelschritte besonders abgewichen sind und die diagnoserelevante Abweichung verursacht haben. Auch hierüber kann ein Anlagenbediener oder Wartungspersonal mit Hilfe eines Alarms oder einer geeigneten grafischen Darstellung informiert werden.

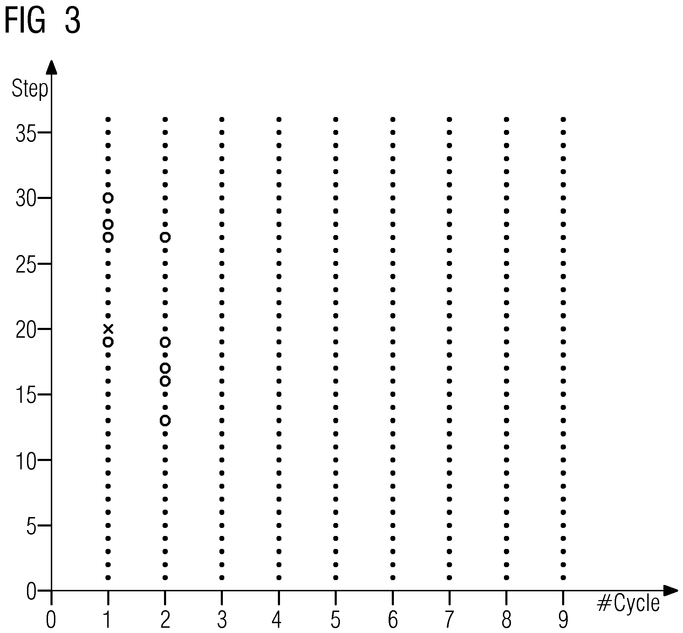

Figur 3 zeigt ein Beispiel einer Darstellung, in welcher einem Bediener Ergebnisse einer Überwachung des Betriebs einer technischen Anlage präsentiert werden können. Aufeinanderfolgend wurden neun Durchläufe einer Schrittkette überprüft. Die Nummer des jeweils geprüften Durchlaufs ist auf der X-Achse, welche mit "#Cycle" beschriftet ist, aufgetragen. Die Ordinate, beschriftet mit "Step", trägt für jeden fünften Schritt die Nummer des jeweiligen Schritts einer Schrittkette mit 36 Schritten. Durch einen im Diagramm eingezeichneten Punkt wird angezeigt, dass die ermittelte Zeitdauer der Ausführung des jeweiligen Schritts keine unzulässigen Abweichungen von einem fehlerfreien Durchlauf aufweist. Ein Kreuz, als "x" eingezeichnet, steht für eine längere Schrittdauer als für einen fehlerfreien Durchlauf erwartet, ein Kreis für eine kürzere. Für einen Bediener ist aufgrund der Unterstützung durch die beschriebene Diagnose nun leicht erkennbar, dass lediglich bei den ersten beiden Durchläufen, die an der Abszisse mit den Zählnummern 1 und 2 versehen sind, Abweichungen aufgetreten sind, die möglicherweise auf einen Fehler in der Anlage hindeuten. In dem Durchlauf Nummer 1 sind die Ausführungszeiten für die Schritte 19, 27, 28 und 30 ungewöhnlich kurz, die Zeitdauer für den Schritt 20 hingegen ungewöhnlich lang. Beim Durchlauf Nummer 2 sind die Zeiten für die Schritte 13, 16, 17, 19 und 27 ungewöhnlich kurz. Aufgrund dieser Hinweise kann der Bediener nun eine weitergehende Diagnose einleiten, um die Fehlerursache genauer zu detektieren.

## Patentansprüche

1. Diagnoseeinrichtung zur Überwachung des Betriebs einer technischen Anlage (1) mit einem Automatisierungssystem (3), wobei die Diagnoseeinrichtung einen Datenspeicher (15), in welchem zumindest ein den Betrieb der Anlage kennzeichnender Datensatz abspeicherbar ist, und eine Auswerteeinrichtung (16) umfasst, durch welche anhand des Datensatzes und einer vorbestimmten, so genannten selbstorganisierenden Karte eine Diagnoseaussage über den Betrieb der Anlage (1) bestimmbar und/oder anzeigbar ist, **dadurch gekennzeichnet,**
**dass** die Auswerteeinrichtung (16) dazu ausgebildet ist, bei einem Anlagenbetrieb mit wiederholt durchlaufenen Schrittketten die Zeitdauer der Ausführung jedes Schrittes eines zu prüfenden Durchlaufs einer Schrittkette zu ermitteln und als eine Koordinate des Datensatzes abzuspeichern, wobei der Datensatz als n-Tupel mit einer vorbestimmten Anzahl n von Koordinaten ausgeführt ist,
**dass** an Knoten der selbstorganisierenden Karte entsprechende n-Tupel mit vorbestimmten Zeitdauern für fehlerfreie Durchläufe der Schrittkette abgelegt sind und
**dass** die Auswerteeinrichtung (16) weiterhin dazu ausgebildet ist, durch Auswertung des Datensatzes anhand der selbstorganisierenden Karte eine Abweichung des Zeitverhaltens beim zu prüfenden Durchlauf der Schrittkette vom Zeitverhalten bei fehlerfreien Durchläufen zu detektieren und anzuzeigen.

2. Diagnoseeinrichtung nach Anspruch 1, **dadurch gekennzeichnet, dass** die Auswerteeinrichtung (16) dazu ausgebildet ist, zur Detektion einer Abweichung des Zeitverhaltens den geringsten kartesischen Abstand zwischen dem Datensatz des zu prüfenden Durchlaufs und den Knoten der selbstorganisierenden Karte zu bestimmen.

3. Diagnoseeinrichtung nach Anspruch 2, **dadurch gekennzeichnet, dass** die Auswerteeinrichtung (16) dazu ausgebildet ist, als Diagnoseaussage eine Abweichung vom Normalverhalten bei dem zu prüfenden Durchlauf der Schrittkette anzuzeigen, wenn der Abstand einen vorbestimmten Schwellwert übersteigt.

4. Diagnoseeinrichtung nach einem der vorhergehenden Ansprüche, **dadurch gekennzeichnet, dass** die Auswerteeinrichtung (16) dazu ausgebildet ist, zur Vorbestimmung der selbstorganisierenden Karte vor einem zu prüfenden Durchlauf im Datenspeicher (15) mehrere, einen fehlerfreien Betrieb der Anlage kennzeichnende Datensätze abzuspeichern und anhand dieser Datensätze durch ein Lernverfahren die n-Tupel mit den Zeitdauern der Ausführung der Schritte für fehlerfreie Durchläufe für die Knoten zu berechnen und an den Knoten der selbstorganisierenden Karte abzulegen.

5. Diagnoseeinrichtung nach Anspruch 4, **dadurch gekennzeichnet, dass** die Auswerteeinrichtung (16) dazu ausgebildet ist, weiterhin vor einem zu prüfenden Durchlauf im Datenspeicher (15) weitere, einen fehlerfreien Betrieb der Anlage kennzeichnende Datensätze abzuspeichern, für die Datensätze jeweils einen Gewinnerknoten zu bestimmen, die jeweiligen maximalen Abstände der Datensätze zu den ihnen zugeordneten Gewinnerknoten zu berechnen und diese, jeweils erhöht um einen Zuschlag zur Vermeidung von Fehldiagnosen, als vorbestimmte, den Gewinnerknoten jeweils zugeordnete Schwellwerte abzuspeichern.

6. Diagnoseeinrichtung nach einem der vorhergehenden Ansprüche, **dadurch gekennzeichnet, dass** die Auswerteeinrichtung (16) dazu ausgebildet ist, bei einer Verzweigung (23) in einer Schrittkette, aufgrund welcher alternative Schritte der Schrittkette bei einem Durchlauf ausführbar sind, für in einem zu prüfenden Durchlauf nicht ausgeführte Schritte den Wert "Null" als Zeitdauer festzulegen und für die Koordinate des Datensatzes abzuspeichern, die für den nicht ausgeführten Schritt vorgesehen ist.

7. Diagnoseeinrichtung nach einem der vorhergehenden Ansprüche, **dadurch gekennzeichnet, dass** die Auswerteeinrichtung (16) dazu ausgebildet ist, bei Vorliegen einer Schleife in einer Schrittkette, aufgrund welcher Schritte der Schrittkette bei einem Durchlauf mehrfach ausführbar sind, beim Einlernen der selbstorganisierenden Karte anhand fehlerfreier Durchläufe für jede Ausführung der Schritte der Schrittkette in einem Durchlauf eine Koordinate des n-Tupels einzurichten und für in einem zu prüfenden Durchlauf der Schrittkette nicht ausgeführte Schleifenschritte den Wert "Null" als Zeitdauer festzulegen und für die Koordinate des Datensatzes abzuspeichern, die dem nicht ausgeführten Schleifenschritt zugeordnet ist.

8. Diagnoseeinrichtung nach einem der vorhergehenden Ansprüche, **dadurch gekennzeichnet, dass** zumindest der Datenspeicher (15) und die Auswerteeinrichtung (16) durch Software auf einem Remote-Service-Rechner zur Ferndiagnose der Anlage (1) implementiert sind.

9. Diagnoseverfahren zur Überwachung des Betriebs einer technischen Anlage (1) mit den folgenden Schritten:
- Abspeichern zumindest eines den Betrieb der Anlage (1) kennzeichnenden Datensatzes in einem Datenspeicher (15),
- Bestimmen einer Diagnoseaussage über den Betrieb der Anlage anhand des Datensatzes und einer vorbestimmten, so genannten selbstorganisierenden Karte,
**gekennzeichnet durch** die weiteren Schritte, die bei einem Anlagenbetrieb mit wiederholt durchlaufenen Schrittketten ausgeführt werden:
- Ermitteln der Zeitdauer der Ausführung jedes Schrittes eines zu prüfenden Durchlaufs einer Schrittkette,
- Abspeichern der zuvor ermittelten Zeitdauern als jeweils eine Koordinate des Datensatzes, wobei der Datensatz als n-Tupel mit einer vorbestimmten Anzahl n von Koordinaten ausgeführt ist,
- Detektieren und Anzeigen von Abweichungen des Zeitverhaltens beim zu prüfenden Durchlauf von fehlerfreien Durchläufen **durch** Auswertung des Datensatzes anhand der selbstorganisierenden Karte, wobei an den Knoten der selbstorganisierenden Karte n-Tupel mit den vorbestimmten Zeitdauern für fehlerfreie Durchläufe der Schrittkette abgelegt sind.

10. Computerprogramm mit durch einen Computer ausführbaren Programmcodeanweisungen zur Implementierung des Verfahrens nach Anspruch 9, wenn das Computerprogramm auf einem Computer ausgeführt wird.

11. Computerprogrammprodukt, insbesondere Datenträger oder Speichermedium mit einem durch einen Computer ausführbaren Computerprogramm gemäß Anspruch 10.

## Claims

1. Diagnosis facility for monitoring the performance of a technical plant (1) with an automation system (3), wherein the diagnosis facility includes a memory (15), in which at least one data set that characterises the performance of the plant can be stored, and an evaluation unit (16), by means of which a diagnostic report on the performance of the plant (1) can be determined and/or displayed using said data set and a predetermined, so-called self-organising map, **characterised in that**,
in the performance of a plant comprising step sequences that run repeatedly, the evaluation unit (16) is designed to determine the duration of the execution of each step of a cycle that is to be checked in a step sequence and to store said duration as a coordinate of the data set, wherein the data set is designed as an n-tuple with a predetermined number n of coordinates,
that corresponding n-tuples with predetermined durations for fault-free runs of the step sequence are stored on nodes of the self-organising map and
that the evaluation unit (16) is further designed to detect and display a deviation of the time response in the cycle of the step sequence that is to be checked from the time response for fault-free cycles by evaluating the data set, using the self-organising map.

2. Diagnosis facility according to claim 1, **characterised in that** the evaluation unit (16) is designed to determine the minimum Cartesian distance between the data set for the cycle that is to be checked and the nodes of the self-organising map in order to detect a deviation in the time response.

3. Diagnosis facility according to claim 2, **characterised in that** the evaluation unit (16) is designed to display as a diagnostic report a deviation from the normal performance in the cycle that is to be checked in the step sequence when the distance exceeds a predetermined threshold value.

4. Diagnosis facility according to one of the preceding claims, **characterised in that** the evaluation unit (16) is designed in order to predetermine the self-organising map, to store in the memory (15), prior to a cycle that is to be checked, a plurality of data sets that characterise a fault-free performance of the plant, and use said data sets to calculate for the nodes, by means of a learning method, the n-tuples with the durations of the execution of the steps for fault-free cycles and store them on the nodes of the self-organising map.

5. Diagnosis facility according to claim 4, **characterised in that** the evaluation unit (16) is designed, again prior to a cycle that is to be checked, to store in the memory (15) further data sets that characterise a fault-free performance of the plant, to determine a winner node for the respective data sets, to calculate the respective maximum distances between the data sets and the winner node assigned thereto, and to store these, increased in each case by an added margin to avoid faulty diagnoses, as predetermined threshold values, assigned in each case to the winner node.

6. Diagnosis facility according to one of the preceding claims, **characterised in that** the evaluation unit (16) is designed, where there is a fork (23) in a step sequence, due to which alternative steps of a step sequence can be carried out during a cycle, to set the value "zero" as the duration for steps that have not been carried out in a cycle that is to be checked and store said value for the data set coordinate provided for the step that has not been carried out.

7. Diagnosis facility according to one of the preceding claims, **characterised in that** the evaluation unit (16) is designed, where there is a loop in a step sequence, due to which steps in a step sequence can be carried out a plurality of times in a cycle, during the learning of the self-organising map using fault-free cycles for each execution of the steps of a step sequence in a cycle, to set a coordinate of the n-tuple and to set the value "zero" as the duration of loop steps that have not been carried out in a cycle of the sequence of steps that is to be checked and store said value for the coordinate of the data set that is assigned to the loop step that has not been carried out.

8. Diagnosis facility according to one of the preceding claims, **characterised in that** at least the memory (15) and the evaluation unit (16) are implemented by software on a Remote Service computer for the remote diagnosis of the plant (1).

9. Diagnostic method for monitoring the performance of a technical plant (1), comprising the following steps:
- storage of at least one data set that characterises the performance of the plant (1) in a memory (15),
- determination of a diagnostic report on the performance of the plant using the data set and a predetermined, so-called self-organising map,
**characterised by** the further steps that are carried out during the performance of a plant with repeatedly run step sequences:
- determining the duration of the execution of each step of a cycle that is to be checked in a step sequence,
- storage of previously determined durations as a respective coordinate of the data set, wherein the data set is designed as an n-tuple with a predetermined number n of coordinates,
- detecting and displaying deviations of the time response in the cycle that is to be checked from fault-free cycles by evaluation of the data set, using the self-organising map, wherein n-tuples with the predetermined time responses for fault-free cycles of the step sequence are stored on the node of the self-organising map.

10. Computer program with programming instructions that are executable on a computer for implementing the method of the invention according to claim 9 when the computer program is run on a computer.

11. Computer program product, in particular a data carrier or storage medium, comprising a computer program according to claim 10 that can be run by a computer.

## Revendications

1. Dispositif de diagnostic pour contrôler le fonctionnement d'une installation (1) technique ayant un système (3) d'automatisation, le dispositif de diagnostic comprenant une mémoire (15) de données, dans laquelle au moins un jeu de données caractérisant le fonctionnement de l'installation peut être mémorisé, et un dispositif (16) d'exploitation par lequel, à l'aide du jeu de données et d'une carte définie à l'avance dite auto-organisatrice, un diagnostic sur le fonctionnement de l'installation (1) peut être déterminé et/ou affiché, **caractérisé,**
**en ce que** le dispositif (16) d'exploitation est constitué pour, lorsque l'installation fonctionne en ayant des chaînes de stades se déroulant de manière répétée, déterminer les durées de la réalisation de chaque stade d'un déroulement à contrôler d'une chaîne de stades et les mémoriser sous la forme d'une coordonnée du jeu de données, le jeu de données étant réalisé sous la forme d'un n-tuple ayant un nombre n défini à l'avance de coordonnées,
**en ce que** des n-tuples, correspondant aux noeuds de la carte auto-organisatrice, sont mémorisés avec des durées définies à l'avance pour des déroulements sans erreur de la chaîne de stades et
**en ce que** le dispositif (16) d'exploitation est constitué, en outre, pour, par exploitation du jeu de données à l'aide de la carte auto-organisatrice, détecter et afficher un écart du comportement dans le temps, lors du déroulement à contrôler de la chaîne de stades, au comportement dans le temps pour des déroulements sans erreur.

2. Dispositif de diagnostic suivant la revendication 1, **caractérisé en ce que** le dispositif (16) d'exploitation est constitué pour déterminer, pour la détection, un écart du comportement dans le temps de la distance cartésienne la plus petite entre le jeu de données du déroulement à contrôler et les noeuds de la carte auto-organisatrice.

3. Dispositif de diagnostic suivant la revendication 2, **caractérisé en ce que** le dispositif (16) d'exploitation est constitué pour afficher, comme diagnostic, un écart au comportement normal lors du déroulement à contrôler de la chaîne de stades, si la distance dépasse une valeur de seuil définie à l'avance.

4. Dispositif de diagnostic suivant l'une des revendications précédentes, **caractérisé en ce que** le dispositif (16) d'exploitation est constitué pour mémoriser, afin de définir à l'avance la carte auto-organisatrice avant un déroulement à contrôler, dans la mémoire (15) de données, plusieurs jeux de données caractérisant un fonctionnement sans erreur de l'installation et, à l'aide de ces jeux de données, pour calculer, pour les noeuds, par un procédé d'apprentissage, les n-tuples ayant les durées de la réalisation des stades pour des déroulements sans erreur et les mémoriser sur les noeuds de la carte auto-organisatrice.

5. Dispositif de diagnostic suivant la revendication 4, **caractérisé en ce que** le dispositif (16) d'exploitation est constitué, en outre, pour mémoriser, avant un déroulement à contrôler, dans la mémoire (15) de données, d'autres jeux de données caractérisant un fonctionnement sans erreur de l'installation, pour déterminer, pour les jeux de données, respectivement un noeud gagnant, pour calculer les distances maximum respectives des jeux de données aux noeuds gagnants qui leur sont associés et pour mémoriser celles-ci, respectivement augmentées d'un supplément pour empêcher des diagnostics défectueux, comme valeurs de seuil déterminées à l'avance, associées respectivement aux noeuds gagnants.

6. Dispositif de diagnostic suivant l'une des revendications précédentes, **caractérisé en ce que** le dispositif (16) d'exploitation est constitué pour, lors d'une ramification (23) dans une chaîne de stades, sur la base de laquelle des stades alternatifs de la chaîne de stades peuvent être réalisés lors d'un déroulement, fixer la valeur "zéro" pour des stades non réalisés dans un déroulement à contrôler et à la mémoriser pour la coordonnée du jeu de données, qui est prévue pour le stade non réalisé.

7. Dispositif de diagnostic suivant l'une des revendications précédentes, **caractérisé en ce que** le dispositif (16) d'exploitation est constitué pour, en présence d'une boucle dans une chaîne de stades, sur la base de laquelle des stades de la chaîne de stades peuvent être réalisés plusieurs fois lors d'un déroulement, établir, lors de l'apprentissage de la carte auto-organisatrice, à l'aide de déroulement sans erreur pour chaque réalisation des stades de la chaîne de stades dans un déroulement, une coordonnée du n-tuple et fixer, comme durée, la valeur "zéro" pour des stades de la boucle, qui ne sont pas réalisés dans un déroulement à contrôler de la chaîne de stades, et la mémoriser pour la coordonnée du jeu de données, qui est associée au stade de boucle non réalisé.

8. Dispositif de diagnostic suivant l'une des revendications précédentes, **caractérisé en ce qu'**au moins la mémoire (15) de données et le dispositif (16) d'exploitation sont mis en oeuvre par logiciel sur un ordinateur de service à distance pour le télédiagnostic de l'installation (1).

9. Procédé de diagnostic pour contrôle le fonctionnement d'une installation (1) technique, comprenant les stades suivants :
- mémorisation d'au moins un jeu de données caractérisant le fonctionnement de l'installation (1) dans une mémoire (15) de données,
- détermination d'un diagnostic sur le fonctionnement de l'installation à l'aide du jeu de données et d'une carte dite auto-organisatrice définie à l'avance,
**caractérisé par** les autres stades, qui sont réalisés dans un fonctionnement de l'installation ayant des chaînes de stades se déroulant de manière répétée :
- détermination de la durée de la réalisation de chaque stade d'un déroulement à contrôle d'une chaîne de stades,
- mémorisation des durées déterminées auparavant, comme respectivement une coordonnée du jeu de données, le jeu de données étant réalisé en n-tuple ayant un nombre n défini à l'avance de coordonnées,
- détection et affichage d'écart du comportement dans le temps lors du déroulement à contrôler de déroulement sans erreur par exploitation du jeu de données à l'aide de la carte auto-organisatrice, dans lequel, sur les noeuds de la carte auto-organisatrice, des n-tuples, ayant les durées définies à l'avance pour des déroulements sans erreur de la chaîne de stades, sont mémorisés.

10. Programme d'ordinateur ayant des instructions de code de programme pouvant être réalisées par un ordinateur pour la mise en oeuvre du procédé suivant la revendication 9, lorsque le programme d'ordinateur est réalisé sur un ordinateur.

11. Produit de programme d'ordinateur, notamment support de données ou support de mémoire ayant un programme d'ordinateur pouvant être réalisé par un ordinateur suivant la revendication 10.
